# EUROPEAN PATENT SPECIFICATION

(11) **EP 2 309 537 B1**
(45) Date of publication and mention of the grant of the patent: **08.06.2016**
(21) Application number: 10176546.9
(22) Date of filing: 14.09.2010
(51) Int. Cl.: H01L 21/761, H03K 17/082, H01L 27/06, H01L 29/36, H01L 29/06, H01L 49/02, H02M 3/158, H01L 29/10

(54) **High voltage floating well in a silicon die**
Schwebende Hochvolt-Wanne in einem Siliziumsubstrat
Puits flottant haute tension dans une puce de silicium

(30) Priority: 17.09.2009 US 562083
(43) Date of publication of application: 13.04.2011
(73) Proprietor: Monolithic Power Systems, Inc., San Jose, CA 95119 (US)
(72) Inventor: Hsing, Michael R., Saratoga, CA 95070 (US); Moyer, James C., San Jose, CA 95129 (US)
(74) Representative: Leach, James

(56) References cited:
- US-A- 4 862 242
- US-A- 5 382 826
- US-A1- 2006 163 691
- US-A1- 2006 220 168
- US-A1- 2009 008 711
- US-B1- 6 680 515

## Description

The present invention relates to semiconductor electronics.

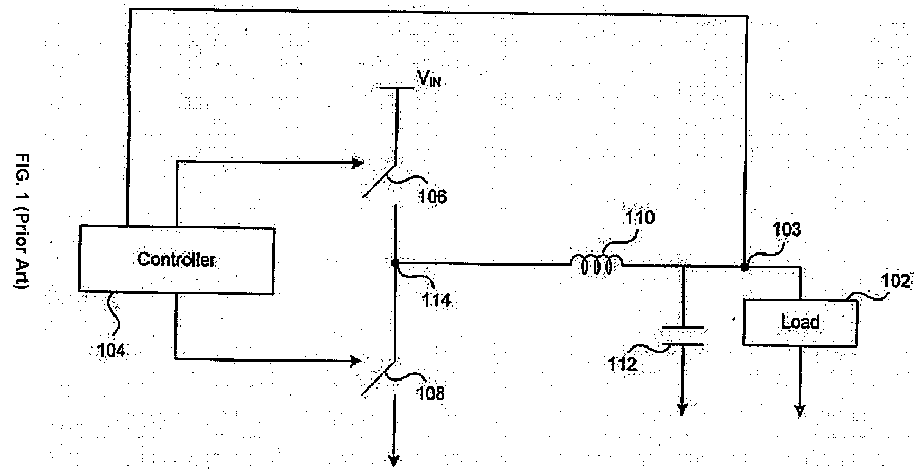

Many DC-to-DC power converters may be conceptualized by the circuit illustrated in Figure 1, where electrical power from a source having a supply voltage VIN is provided to load 102 such that the load voltage is regulated to some voltage less than VIN. A feedback path is provided from node 103 to controller 104, where controller 104 controls the duty cycle of high-side switch 106 and low-side switch 108 to regulate the load voltage. A second-order low pass filter comprising inductor 110 and capacitor 112 couples load 102 to switch point 114 so as to smooth output ripples. In practice, switches 106 and 108 are power MOSFETs (Metal-Oxide-Semiconductor-Field-Effect-Transistor), where each power MOSFET is realized by a large number of individual MOSFETs connected in parallel. The operating principles for the circuit of Figure 1 are well known to those skilled in the art of power converters, and need not be repeated here.

For some consumer applications, the supply voltage VIN may peak to several hundred volts, in which case the voltage drop across switch 106 or 108 may also peak to several hundred volts. Accordingly, for such applications, switches 106 and 108 are preferably designed to operate under such high voltage drops.

In practice, most or all of the circuit components in an embodiment, except for inductor 110, capacitor 112, load 102, and perhaps some discrete resistors and capacitors, are integrated on a single silicon die. Some circuit components within controller 104 may be connected to the supply voltage VIN. However, various circuit components within controller 104 may in practice be designed to operate over voltage drops not to exceed on the order of ten volts. For example, a circuit block within controller 104 may be connected to a high voltage pin, yet the circuit block may be designed for voltage drops not to exceed on the order of ten volts. Accordingly, it may be desirable to electrically isolate such circuits from high voltage drops to avoid device breakdown.

US4862242 discloses a semiconductor wafer having a substrate with an epitaxial layer thereon that includes a semiconductor device electrically isolated from the substrate as well as from any other devices in the wafer by electrical isolation structure comprising semiconductor material. The semiconductor device can accordingly be operated at high voltage with respect to the wafer substrate. The isolation structure in one form of the wafer comprises an N+ high voltage tub included in the wafer and a P+ ground region situated in the expitaxial layer, adjoining the substrate, and horizontally circumscribing the N+ high voltage tub and being spaced therefrom by a minimum layer extent of a portion of the epitaxial layer that is of N conductivity type. The N+ high voltage tub comprises an N+ high voltage region situated in the epitaxial layer and surrounding a device region in which the semiconductor device is at least partially contained and, further, an N+ buried layer underlying the N+ high voltage region and the entirety of the device region.

US5382826 discloses a semiconductor structure having an edge termination feature wherein a first doped region and a second doped region are selectively formed in a semiconductor layer. The second doped region is coupled with the first doped region and has an impurity concentration less than that of the first doped region. An insulating layer is disposed over the semiconductor layer and over at least a portion of the second doped region. A conductive layer, having a coil-shaped configuration, is disposed over the insulating layer and is coupled to the semiconductor layer.

US20060163691 discloses a high voltage element formed overlying a doped semiconductor region that can be depleted during the operation of the high voltage element.

US6680515 discloses a lateral high voltage transistor device. The transistor includes a gate, a drain, and a source. The drain is located apart from the gate to form an intermediate drift region. The drift region has variable dopant concentration between the drain and the gate. In addition, a spiral resistor is placed over the drift region and is connected to the drain and either the gate or the source of the transistor.

The invention provides an article of manufacture as set out in claim 1. Further aspects of the invention are set out in the remaining claims.

### BRIEF DESCRIPTION OF THE DRAWINGS

Figure 1 illustrates a prior art DC-to-DC power converter.
Figure 2 illustrates a cross-sectional plan view of an embodiment.
Figure 3 illustrates a top plan view of an embodiment.

In the description that follows, the scope of the term "some embodiments" is not to be so limited as to mean more than one embodiment, but rather, the scope may include one embodiment, more than one embodiment, or perhaps all embodiments.

Although embodiments find application to DC-to-DC power converters, embodiments are not limited to such applications. In this Description of Embodiments, the region of the silicon die that is electrically isolated from high voltage drops may be termed a floating well.

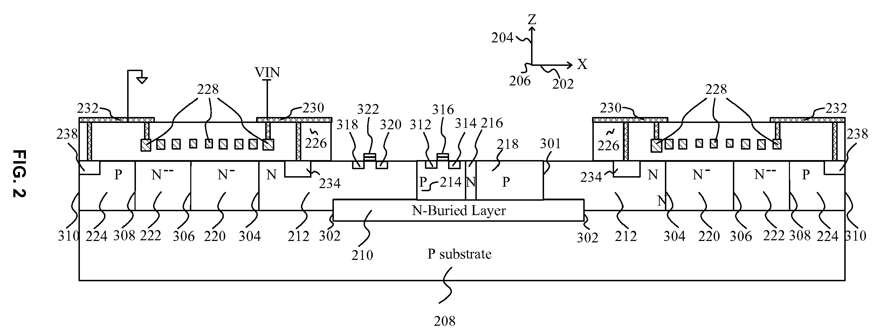

Figure 2 illustrates a cross-sectional plan view of a portion of a silicon die according to an embodiment. For ease of illustration, Figure 2 is not drawn to scale, and various doped regions are idealized as rectangles. For reference, shown in Figure 2 is a coordinate system with x-axis 202 and z-axis 204 lying in the plane of illustration, with y-axis 206 pointing into the plane of the illustration. With the coordinate system as shown, the cross-sectional view illustrated in Figure 2 is taken as a slice of an embodiment, with the slice perpendicular to y-axis 206.

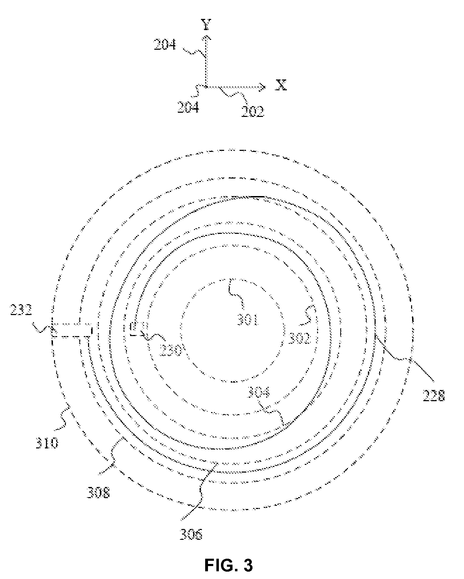

Figure 3 illustrates a cross-sectional plan view of a portion of the silicon die according to an embodiment, but with a different view than that of Figure 2. To provide relative orientations of the embodiment of Figure 2 and the embodiment of Figure 3, the coordinate system in Figure 2 is also shown in Figure 3, making clear that the cross-sectional view illustrated in Figure 3 is a slice of an embodiment, with the slice taken perpendicular to z-axis 204. For ease of illustration, Figure 3 is not drawn to scale.

Referring to Figure 2, formed in p-doped substrate 208 is n-doped buried layer 210. Adjacent to n-doped buried layer 210 are several regions of the silicon die, where for simplicity only three such regions are illustrated in Figure 2, and are labeled 212, 214, 216, and 218. Regions 212 and 216 are n-doped regions, and regions 214 and 218 are p-doped regions. Other embodiments may have more or less such regions adjacent to n-doped buried layer 210, but the outermost region adjacent to n-doped buried layer 210 is n-doped.

Region 212 in Figure 2 appears noncontiguous only because of the way the slice is taken to provide the view of the illustration, but for the embodiments of Figures 2 and 3, region 212 is contiguous and surrounds n-doped buried layer 210. This is made clear by the view illustrated in Figure 3, where dashed circle 302 in Figure 3 corresponds to outer edge 302 of n-doped buried layer 210 in Figure 2, and dashed circles 304 and 306 in Figure 3 correspond, respectively, to junctions 304 and 306 in Figure 2, where junction 304 is the junction between n-doped regions 212 and 220, and junction 306 is the junction between n-doped regions 220 and 222.

Region 212 lies between dashed circles 301 and 304 in Figure 3, and is shown as an annulus. However, in practice n-doped region 212 may not be exactly circular in shape, and for some embodiments, n-doped region 212 may take on other geometric shapes, or it may be irregular.

In Figure 2, labels 214 and 218 represent noncontiguous regions.

Adjacent to n-doped region 212 is n-doped region 220 surrounding n-doped region 212, represented by the annulus between dashed circles 304 and 306 in Figure 3. N-doped region 220 is doped less than n-doped region 212, as indicated by the symbol N- in Figure 2. Adjacent to n-doped region 220 is n-doped region 222 surrounding n-doped region 220, represented by the annulus between dashed circles 306 and 308 in Figure 3. N-doped region 222 is doped less than n-doped region 220, as indicated by the symbol N-- in Figure 2. Adjacent to n-doped region 222 is p-doped region 224, represented by the annulus between dashed circles 308 and 310 in Figure 3. Regions 220, 222, and 224 may not be exactly circular in shape, and for some embodiments, may take on other geometric shapes, or they may be irregular.

n-doped buried layer 210 is represented by the region inside dashed circle 302 in Figure 3. For the embodiment of Figure 3, n-doped buried layer 210 is illustrated as having a disk shape, but other embodiments may utilize different shapes for region 210. For ease of illustration, regions 214, 216, and 218 are not shown in Figure 3.

Referring to Figure 2, label 226 denotes a dielectric layer, such as for example SiO2. For ease of illustration, Figure 2 shows that the dielectric layer on some or all of regions 212, 214, 216, and 218 above n-doped buried layer 210 has been removed, but in practice a dielectric layer may be deposited over these regions.

Formed in oxide layer 226 is spiral resistor 228. Spiral resistor 228 may also be referred to as a spiral field plate. In Figure 2, the cross-sectional view of spiral resistor 228 is indicated by hatched rectangles. Solid spiral line 228 in Figure 3 represents spiral resistor 228, however, a simplification is made because the number of turns of spiral resistor 228 as shown in Figure 3 is less than the number of turns represented in Figure 2. Also, for simplicity all turns in Figure 3 are shown equal in thickness (in the x-y plane), whereas this is not so for Figure 2. Furthermore, for clarity of illustration, the scale of the various regions in Figure 3 does not match that of Figure 2. The slice in Figure 3 is taken along spiral resistor 228 in the x-y plane, hence other structures in Figure 3 are shown dashed because they are present below or above (along the z-axis dimension) the slice.

The inner ring of spiral resistor 228 is electrically connected to n-doped region 212. For example, in embodiments represented by the illustrations in Figures 2 and 3, the inner ring of spiral resistor 228 is connected to n-doped region 212 by way of highly doped n-region 234, and by a set of vias and an interconnect, collectively labeled by the numeral 230, and shown cross-hatched in the illustration of Figure 2 and as a dashed rectangle in Figure 3. Region 234 is a highly doped n-region to provide a good electrical contact between spiral resistor 228 and region 212, so that highly doped n-region 234 and set of vias and interconnect 230 serve as an ohmic contact.

The outer ring of spiral resistor 228 is electrically connected to p-doped region 224. For example, in embodiments represented by the illustrations in Figures 2 and 3, the outer ring of spiral resistor 228 is connected to p-doped region 224 by way of highly doped p-region 238, and by a set of vias and an interconnect, collectively labeled by the numeral 232, and shown cross-hatched in the illustration of Figure 2 and as a dashed rectangle in Figure 3. Region 238 is a highly doped p-region to provide a good electrical contact between spiral resistor 228 and region 224, so that highly doped p-region 238 and set of vias and interconnect 232 serve as an ohmic contact.

Spiral resistor 228 may not be exactly a spiral, and for some embodiments spiral resistor 228 may not have a spiral shape. For some embodiments, spiral resistor 228 may meander from above region 212 to above region 222. Some embodiments may have spiral resistor 228 comprising straight sections, so as to enclose a region somewhat rectangular in nature, but with curved corners. Accordingly, in general, the descriptive term "spiral resistor" is not meant to imply that the resistor coupling outer p-doped region 224 to n-doped region 212 is necessarily spiral in shape.

For some embodiments, spiral resistor 228 may comprise polysilicon. Well known design techniques may be used so that spiral resistor 228 has some desired resistance. For example, for some embodiments the sheet resistance of the polysilicon used for spiral resistor 228 may be from 1KΩ/square to 5KΩ/square, and a typical resistance for spiral resistor 228 may be in the neighborhood of 60MΩ. For some embodiments, the typical radii of curvature for the bends in spiral resistor 228 may be in the neighborhood of 100µm to 200µm. These numerical values are given merely to provide examples. Other embodiments may have numerical values not represented by these numerical ranges or values.

Regions 212, 220, and 222 provide a graded doping profile. For simplicity, only three such graduations or steps in doping are shown, but other embodiments may have a different number of such graduations or steps in doping level. As an example of doping levels, region 212 may have a doping level where the doping profile is such that region 220 is doped at 1/10 the level of region 212, and region 222 is doped at 1/10 the level of region 220. These numerical values are given merely to provide examples. Other embodiments may have numerical values not represented by these numerical ranges or values.

In practice, during operation of the circuit fabricated in the silicon die, the interconnect represented by label 230 may be at a first voltage potential, and the interconnect represented by label 232 may be at a second voltage potential different from the first voltage potential. As a result, in operation the voltage potential of region 212 and n-doped buried layer 210 may be at the first voltage potential, and p-doped region 224 may be at the second voltage potential. The difference in these voltage potentials may be relatively high, for example several hundred volts, as may be the case for consumer power converters. As a particular example, in Figure 2 the metal interconnect represented by label 230 is shown to be at the supply voltage VIN, and the metal interconnect represented by label 232 is shown to be at ground potential.

The voltage potential difference discussed above appears across spiral resistor 228, but if the resistance of spiral resistor 228 is sufficiently high, the resulting current may be set to a relatively low value to reduce wasted power and heat. Spiral resistor 228 sets the voltage potential at the surface of regions 212, 220, and 222, so as to mitigate high electric fields that may cause breakdown. The graded doping profile provided by regions 212, 220, and 222 profiles the depletion region between p-substrate 208 and n-doped regions 212, 220, 222 so that the depletion region has less depth towards p-doped region 224, thereby mitigating punch-through. Accordingly, spiral resistor 228 and the grading of the n-doping in the lateral dimension (x-y plane) help to electrically isolate regions 212, 214, 216, and 218, and n-doped buried layer 210, from parts of the silicon die that are physically placed outside of p-doped region 224. This is important for devices integrated in regions 212, 214, 216, and 218 that may be at or near the high voltage VIN, but where the voltage drops across such devices may be only on the order of ten volts.

For the embodiment of Fig 2, the floating well may be considered to include the doped silicon inside circular junction 304, including n-doped buried layer 210. In general, the floating well (e.g. regions 210, 212, 214, 216, and 218) may float from a relatively high voltage, such as for example +700V above ground (or the p-substrate) to a much lower positive voltage, ground voltage, or a forward biased diode voltage drop below ground. Devices and circuits within such a floating well may operate at a high voltage with respect to ground, but at a low to medium voltage with respect to the floating well.

The particular value of the substrate voltage in a packaged integrated circuit depends upon the application, so for some applications the floating well may be held at 0V and the p-doped substrate voltage may move from 0V to -700V, for example. This may be done throughout the operating voltage range, for example, the floating well may be at +350V and the p-doped substrate at -350V, and so forth. For some embodiments, the volume resistivity of p-doped substrate 208 may be in the neighborhood of 80 ohm-cm, or greater, so that a breakdown voltage of about 700V may be obtained between n-doped buried layer 210 and p-doped substrate 208, whereas spiral resistor 228 and graded regions 212, 220, and 222 provide for a high breakdown voltage in the lateral dimension (x-y plane).

All devices within the floating well may be electrically isolated from the substrate, up to some breakdown voltage. P-well regions 214 and 218 are electrically isolated from each other by the n-well region 216 within the floating well for the embodiment of Fig 2. For example, depending upon the device layout and the process technology used, devices within each p-well region may have an operating voltage, with respect to the p-doped substrate, ranging from the breakdown voltage to the breakdown voltage minus 20V to 60V, but because of the isolation, each such device experiences a relatively small voltage drop in the range of 20V to 60V. Examples of active devices using a p-well region inside the floating well may be an nMOSFET, an NPN transistor using the p-well region as a base and the n-doped buried layer as a collector, or a 20-60V pMOSFET using the p-well region as a drain extension. As a specific example, shown in Figure 2 is an nMOSFET comprising n-doped source and drain regions 312 and 314, and gate 316 (underneath gate 316 is an oxide layer). These are merely a few examples, but in general any type of device and process for p-wells may be a candidate for p-wells within a floating well described by the embodiments.

N-well regions inside the floating well for the embodiment of Fig 2 (regions 212 and 216), are all at the same voltage potential because they are electrically connected to each other by the n-doped buried layer. Devices fabricated in an n-well within a floating well may have the same operating voltage range as discussed previously with respect to p-wells within the floating well, depending on the device layout and the process. Devices fabricated in an n-well region within a floating well may be a pMOSFET, a lateral PNP device, or other types of devices, where any device that can be fabricated within an n-well may be a candidate for an n-well within a floating well described by the embodiments. As a specific example, shown in Figure 2 is a pMOSFET comprising p-doped source and drain regions 318 and 320, and gate 322 (underneath gate 322 is an oxide layer).

Various modifications may be made to the described embodiments without departing from the scope of the invention as claimed below.

It is to be understood in these letters patent that the meaning of "A is connected to B", where for example A or B may be, but are not limited to, a node, a device terminal, or a port, is that A and B are electrically connected to each other by a conductive structure so that for frequencies within the signal bandwidth of interest, the resistance, capacitance, and inductance introduced by the conductive structure may each be neglected. For example, a transmission line (e.g., microstrip), relatively short compared to the signal wavelength of interest, may be designed to introduce a relatively small impedance, so that two devices in electrical contact at each end of the transmission line may be considered to be connected to one another.

It is also to be understood in these letters patent that the meaning of "A is coupled to B" is that either A and B are connected to each other as described above, or that, although A and B may not be connected to each other as described above, there is nevertheless a device or circuit that is connected to both A and B so that a properly defined voltage or current at one of the two elements A or B has some effect on a properly defined voltage or current at the other of the two elements.

## Claims

1. An article of manufacture comprising:
a semiconductor comprising:
a substrate (208);
an n-doped buried layer (210) adjacent to the substrate (208);
an n-doped region (212, 220, 222) adjacent to the n-doped buried layer (210) and the substrate (208), the n-doped region (212, 220, 222) comprising a first n-doped region (212) adjacent to the n-doped buried layer (210) and having a first doping concentration, and a last n-doped region (222) having a last doping concentration less than the first doping concentration; and
a p-doped region (224) adjacent to the last n-doped region (222) and to the substrate (210);
wherein the article of manufacture is **characterized in that**:
the last n-doped region (222) is not adjacent to the n-doped buried layer (210);
the semiconductor further comprises at least two isolated p-doped regions (214, 218) adjacent to the first n-doped region (212) and the n-doped buried layer (210), wherein the first n-doped region (212) surrounds the isolated p-doped regions (214, 218) and the isolated p-doped regions (214, 218) are electrically isolated from each other by at least one n-well region (216); and
the article of manufacture further comprises a resistor (228) electrically coupled to the first n-doped region (212) and to the p-doped region (224).

2. The article of manufacture as set forth in claim 1, wherein the p-doped region (224) is part of the substrate (208).

3. The article of manufacture as set forth in claim 1, further comprising:
a dielectric layer (226) formed on the n-doped region (212, 220, 222) and the p-doped region (224), wherein the resistor (228) is formed in the dielectric layer (226);
a first ohmic contact (234) to electrically couple the resistor (228) to the first n-doped region (212); and
a second ohmic contact (232) to electrically couple the resistor (228) to the p-doped region (224).

4. The article of manufacture as set forth in claim 3, wherein:
the first ohmic contact (234) comprises a highly doped n-region (234) in the first n-doped region (212), a first via (230) in the dielectric layer (226) connected to the highly doped n-region (234), an interconnect (230) connected to the first via (230), and a second via (230) in the dielectric layer (226) connected to the interconnect (230) and to the resistor (228); and;
the second ohmic contact (238) comprises a highly doped p-region (238) in the p-doped region (224), a first via (232) in the dielectric layer (226) connected to the highly doped p-region (238), an interconnect (232) connected to the first via (232) of the second ohmic contact (238), and a second via (232) in the dielectric layer (226) connected to the interconnect (232) of the second ohmic contact (238) and to the resistor (228).

5. The article of manufacture as set forth in claim 1, the n-doped region (212, 220, 222) comprising a second n-doped region (220) adjacent to the first n-doped region (212) and the substrate (208), and having a second doping concentration less than the first doping concentration and greater than the last doping concentration.

6. The article of manufacture as set forth in claim 1, wherein a portion of the resistor (228) surrounds the first n-doped region (212).

7. The article of manufacture as set forth in claim 6, wherein the resistor (228) surrounds the first n-doped region (212).

8. The article of manufacture as set forth in claim 6, wherein the resistor (228) has a spiral shape.

9. The article of manufacture as set forth in claim 1, wherein the last n-doped region (222) surrounds the first n-doped region (212), and the p-doped region (224) surrounds the last n-doped region (222).

10. The article of manufacture as set forth in claim 1, further comprising an active device (312, 316, 314) integrated in one of the isolated p-doped regions (214, 218).

11. The article of manufacture as set forth in claim 1, wherein:
a well (210, 212, 214, 216, 218) is in contact with the substrate (208), the well (210, 212, 214, 216, 218) comprising the n-doped buried layer (210) in contact with the substrate (208), and the first n-doped region (212) in contact with the n-doped buried layer (208); and
a graded n-doped region (220, 222) has a graded doping concentration in contact with the substrate (208) and the first n-doped region (212) of the well.

12. The article of manufacture as set forth in claim 11, wherein the graded n-doped region (220, 222) surrounds the well (210, 212, 214, 216, 218).

13. The article of manufacture as set forth in claim 11, the well (210, 212, 214, 216, 218) further comprising a transistor (318, 322, 320) formed in the first n-doped region (212) of the well.

14. The article of manufacture as set forth in claim 13, the well (210, 212, 214, 216, 218) further comprising the isolated p-doped regions (214, 218) in contact with the n-doped buried layer (210), and a transistor (312, 316, 314) is formed in one of theisolated p-doped regions (214, 218) of the well (210, 212, 214, 216, 218).

## Patentansprüche

1. Fabrikat, das Folgendes umfasst:
einen Halbleiter, der Folgendes umfasst:
ein Substrat (208);
eine n-dotierte vergrabene Schicht (210), benachbart zu dem Substrat (208);
eine n-dotierte Region (212, 220, 222), benachbart zu der n-dotierten vergrabenen Schicht (210) und dem Substrat (208), wobei die n-dotierte Region (212, 220, 222) eine erste n-dotierte Region (212), benachbart zu der n-dotierten vergrabenen Schicht (210) und die eine erste Dotierkonzentration aufweist, und eine letzte n-dotierte Region (222) umfasst, die eine letzte Dotierkonzentration aufweist, die geringer ist als die erste Dotierkonzentration; und
eine p-dotierte Region (224), benachbart zu der letzten n-dotierten Region (222) und zu dem Substrat (210);
worin das Fabrikat **dadurch gekennzeichnet ist, dass**:
die letzte n-dotierte Region (222) nicht benachbart zu der n-dotierten vergrabenen Schicht (210) ist;
der Halbleiter ferner zumindest zwei isolierte p-dotierte Regionen (214, 218), benachbart zu der ersten n-dotierten Region (212) und der n-dotierten vergrabenen Schicht (210) umfasst, worin die erste n-dotierte Region (212) die isolierten p-dotierten Regionen (214, 218) umgibt und die isolierten p-dotierten Regionen (214, 218) elektrisch durch zumindest eine n-Topfregion (216) voneinander isoliert sind; und
das Fabrikat ferner einen Widerstand (228) umfasst, der elektrisch mit der ersten n-dotierten Region (212) und der p-dotierten Region (224) gekoppelt ist.

2. Fabrikat nach Anspruch 1, worin die p-dotierte Region (224) Teil des Substrats (208) ist.

3. Fabrikat nach Anspruch 1, das ferner Folgendes umfasst:
eine dielektrische Schicht (226), die auf der n-dotierten Region (212, 220, 222) und der p-dotierten Region (224) gebildet ist, worin der Widerstand (228) in der dielektrischen Schicht (226) gebildet ist;
einen ersten ohmschen Kontakt (234), um den Widerstand (228) elektrisch mit der ersten n-dotierten Region (212) zu koppeln; und
einen zweiten ohmschen Kontakt (232), um den Widerstand (228) elektrisch mit der p-dotierten Region (224) zu koppeln.

4. Fabrikat nach Anspruch 3, worin:
der erste ohmsche Kontakt (234) eine hochdotierte n-Region (234) in der ersten n-dotierten Region (212), eine erste Durchkontaktierung (230) in der dielektrischen Schicht (226), verbunden mit der hochdotierten n-Region (234), eine Zwischenverbindung (230), verbunden mit der ersten Durchkontaktierung (230), und eine zweite Durchkontaktierung (230) in der dielektrischen Schicht (226), verbunden mit der Zwischenverbindung (230) und dem Widerstand (228) umfasst; und;
der zweite ohmsche Kontakt (238) eine hochdotierte n-Region (238) in der p-dotierten Region (224), eine erste Durchkontaktierung (232) in der dielektrischen Schicht (226), verbunden mit der hochdotierten p-Region (238), eine Zwischenverbindung (232), verbunden mit der ersten Durchkontaktierung (232) des zweiten ohmschen Kontakts (238), und eine zweite Durchkontaktierung (232) in der dielektrischen Schicht (226), verbunden mit der Zwischenverbindung (232) des zweiten ohmschen Kontakts (238) und mit dem Widerstand (228) umfasst.

5. Fabrikat nach Anspruch 1, wobei die n-dotierte Region (212, 220, 222) eine zweite n-dotierte Region (220), benachbart zu der ersten n-dotierten Region (212) und dem Substrat (208), umfasst und eine zweite Dotierkonzentration aufweist, die geringer ist als die erste Dotierkonzentration und größer ist als die letzte Dotierkonzentration.

6. Fabrikat nach Anspruch 1, worin ein Teil des Widerstands (228) die erste n-dotierte Region (212) umgibt.

7. Fabrikat nach Anspruch 6, worin der Widerstand (228) die erste n-dotierte Region (212) umgibt.

8. Fabrikat nach Anspruch 6, worin der Widerstand (228) eine Spiralform aufweist.

9. Fabrikat nach Anspruch 1, worin die letzte n-dotierte Region (222) die erste n-dotierte Region (212) umgibt und die p-dotierte Region (224) die letzte n-dotierte Region (222) umgibt.

10. Fabrikat nach Anspruch 1, das ferner eine aktive Vorrichtung (312, 316, 314) umfasst, die in eine der isolierten p-dotierten Regionen (214, 218) integriert ist.

11. Fabrikat nach Anspruch 1, worin:
ein Topf (210, 212, 214, 216, 218) in Kontakt mit dem Substrat (208) steht, wobei der Topf (210, 212, 214, 216, 218) die n-dotierte vergrabene Schicht (210) in Kontakt mit dem Substrat (208) und die erste n-dotierte Region (212) in Kontakt mit der n-dotierten vergrabenen Schicht (208) umfasst; und
eine abgestuft n-dotierte Region (220, 222) eine abgestufte Dotierkonzentration in Kontakt mit dem Substrat (208) und der ersten n-dotierten Region (212) des Topfs aufweist.

12. Fabrikat nach Anspruch 11, worin die abgestuft n-dotierte Region (220, 222) den Topf (210, 212, 214, 216, 218) umgibt.

13. Fabrikat nach Anspruch 11, wobei der Topf (210, 212, 214, 216, 218) ferner einen Transistor (318, 322, 320) umfasst, der in der ersten n-dotierten Region (212) des Topfes ausgebildet ist.

14. Fabrikat nach Anspruch 13, wobei der Topf (210, 212, 214, 216, 218) ferner die isolierten p-dotierten Regionen (214, 218) in Kontakt mit der n-dotierten vergrabenen Schicht (210) umfasst und ein Transistor (312, 316, 314) in einer der isolierten p-dotierten Regionen (214, 218) des Topfes (210, 212, 214, 216, 218) ausgebildet ist.

## Revendications

1. Article de fabrication comprenant :
un semi-conducteur comprenant :
un substrat (208) ;
une couche enterrée dopée n (210) adjacente au substrat (208) ;
une région dopée n (212, 220, 222) adjacente à la couche enterrée dopée n (210) et au substrat (208), la région dopée n (212, 220, 222) comprenant une première région dopée n (212) adjacente à la couche enterrée dopée n (210) et ayant une première concentration de dopage, et une dernière région dopée n (222) ayant une dernière concentration de dopage inférieure à la première concentration de dopage ; et
une région dopée p (224) adjacente à la dernière région dopée n (222) et au substrat (210) ;
dans lequel l'article de fabrication est **caractérisé en ce que** :
la dernière région dopée n (222) n'est pas adjacente à la couche enterrée dopée n (210) ;
le semi-conducteur comprend en outre au moins deux régions dopées p isolées (214, 218) adjacentes à la première région dopée n (212) et à la couche enterrée dopée n (210), dans lequel la première région dopée n (212) entoure les régions dopées p isolées (214, 218) et les régions dopées p isolées (214, 218) sont isolées électriquement l'une de l'autre par au moins une région de puits n (216) ; et
l'article de fabrication comprend en outre une résistance (228) couplée électriquement à la première région dopée n (212) et à la région dopée p (224).

2. Article de fabrication selon la revendication 1, dans lequel la région dopée p (224) est une partie du substrat (208).

3. Article de fabrication selon la revendication 1, comprenant en outre :
une couche diélectrique (226) formée sur la région dopée n (212, 220, 222) et la région dopée p (224), dans lequel la résistance (228) est formée dans la couche diélectrique (226) ;
un premier contact ohmique (234) pour coupler électriquement la résistance (228) à la première région dopée n (212) ; et
un deuxième contact ohmique (232) pour coupler électriquement la résistance (228) à la région dopée p (224).

4. Article de fabrication selon la revendication 3, dans lequel :
le premier contact ohmique (234) comprend une région fortement dopée n (234) dans la première région dopée n (212), un premier trou traversant (230) dans la couche diélectrique (226) connecté à la région fortement dopée n (234), une interconnexion (230) connectée au premier trou traversant (230), et un deuxième trou traversant (230) dans la couche diélectrique (226) connecté à l'interconnexion (230) et à la résistance (228) ; et
le deuxième contact ohmique (238) comprend une région fortement dopée p (238) dans la région dopée p (224), un premier trou traversant (232) dans la couche diélectrique (226) connecté à la région fortement dopée p (238), une interconnexion (232) connectée au premier trou traversant (232) du deuxième contact ohmique (238), et un deuxième trou traversant (232) dans la couche diélectrique (226) connecté à l'interconnexion (232) du deuxième contact ohmique (238) et à la résistance (228).

5. Article de fabrication selon la revendication 1, dans lequel la région dopée n (212, 220, 222) comprend une deuxième région dopée n (220) adjacente à la première région dopée n (212) et au substrat (208), et a une deuxième concentration de dopage inférieure à la première concentration de dopage et supérieure à la dernière concentration de dopage.

6. Article de fabrication selon la revendication 1, dans lequel une partie de la résistance (228) entoure la première région dopée n (212).

7. Article de fabrication selon la revendication 6, dans lequel la résistance (228) entoure la première région dopée n (212).

8. Article de fabrication selon la revendication 6, dans lequel la résistance (228) a une forme en spirale.

9. Article de fabrication selon la revendication 1, dans lequel la dernière région dopée n (222) entoure la première région dopée n (212), et la région dopée p (224) entoure la dernière région dopée n (222).

10. Article de fabrication selon la revendication 1, comprenant en outre un dispositif actif (312, 316, 314) intégré dans l'une des régions dopées p isolées (214, 218).

11. Article de fabrication selon la revendication 1, dans lequel :
un puits (210, 212, 214, 216, 218) est en contact avec le substrat (208), le puits (210, 212, 214, 216, 218) comprenant la couche enterrée dopée n (210) en contact avec le substrat (208), et la première région dopée n (212) en contact avec la couche enterrée dopée n (208) ; et
une région dopée n graduelle (220, 222) a une concentration de dopage graduelle en contact avec le substrat (208) et la première région dopée n (212) du puits.

12. Article de fabrication selon la revendication 11, dans lequel la région dopée n graduelle (220, 222) entoure le puits (210, 212, 214, 216, 218).

13. Article de fabrication selon la revendication 11, dans lequel le puits (210, 212, 214, 216, 218) comprend en outre un transistor (318, 322, 320) formé dans la première région dopée n (212) du puits.

14. Article de fabrication selon la revendication 13, dans lequel le puits (210, 212, 214, 216, 218) comprend en outre les régions dopées p isolées (214, 218) en contact avec la couche enterrée dopée n (210), et un transistor (312, 316, 314) est formé dans l'une des régions dopées p isolées (214, 218) du puits (210, 212, 214, 216, 218).
